**Europäisches Patentamt**

**European Patent Office**

**Office européen des brevets**

(11) Publication number: **0 066 265**
**B1**

## (12) EUROPEAN PATENT SPECIFICATION

(45) Date of publication of patent specification: **07.12.88**

(21) Application number: **82104649.7**

(22) Date of filing: **27.05.82**

(51) Int. Cl.⁴: **H 03 M 1/82**

(54) D-A converter.

(30) Priority: **27.05.81 JP 80566/81**

(43) Date of publication of application:
**08.12.82 Bulletin 82/49**

(45) Publication of the grant of the patent:
**07.12.88 Bulletin 88/49**

(84) Designated Contracting States:
**DE FR GB**

(56) References cited:
**FR-A-2 046 896**
**FR-A-2 110 396**
**GB-A-2 000 653**

(73) Proprietor: **MITSUBISHI DENKI KABUSHIKI KAISHA**
**2-3, Marunouchi 2-chome Chiyoda-ku Tokyo 100 (JP)**

(72) Inventor: **Takebe, Hideharu c/o Mitsubishi Denki K.K.**
**Kitaitami Works No. 1, Mizuhara 4-chome Itami-shi Hyogo (JP)**
Inventor: **Kobayashi, Hiroshi c/o Mitsubishi Denki K.K.**
**Kitaitami Works No. 1, Mizuhara 4-chome Itami-shi Hyogo (JP)**

(74) Representative: **Lehn, Werner, Dipl.-Ing. et al Hoffmann, Eitle & Partner Patentanwälte Arabellastrasse 4 D-8000 München 81 (DE)**

# Description

The present invention relates to a D—A converter for converting digital data composed of most significant M bits $D_{N+1}, ---, D_{N+M}$, and least significant N bits $D_1, ---, D_N$ where M and N are positive integers respectively into an analog quantity.

GB—A—2000653 discloses a digital-to-analogue converter of pulse width modulation type in which most significant bits and least significant bits are processed separately. In order to allow the analogue output to follow changes in digital input data sufficiently rapidly, elementary pulses in a number determined in dependence on the logic values of the most significant bits are distributed among elementary periods divided from a signal counting cycle of a clock pulse counter. This is achieved by using a comparator circuit receiving the most significant bits of data and the least significant bits from the counter stages.

In FR—A—2110396 all data bits are processed in common and a type of pulse rate modulation (PRM) is employed.

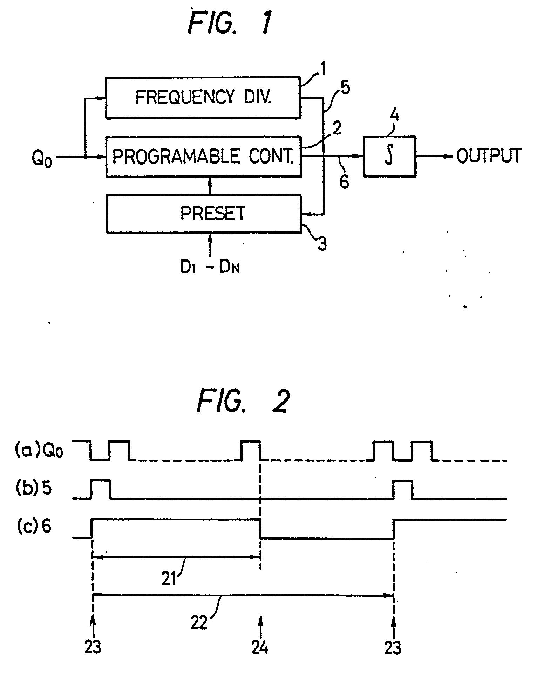

Figure 1 of the accompanying drawings shows a known converter utilizing pulse width modulation and Figure 2 illustrates operation of the modulation system. The conventional system will now be explained briefly. Referring to Figure 1, the system comprises a frequency divider 1 having a counter incorporated therein, a programmable counter 2, a preset circuit 3, and an integrating circuit 4. In Figure 2, is shown a reference clock signal $Q_o$, an output signal 5 of the frequency divider 1, and an output signal 6 of the programmable counter 2. First, the frequency of reference clock signal $Q_o$ is divided by the frequency divider 1 to determine a period of the output signal 6, that is, an interval 22 in Figure 2 is determined. At a time 23, a value corresponding to a digital data $D_1$—$D_N$ is present in the programmable counter 2 through the present circuit 3. The present value in the programmable counter 2 is subtracted by the clock $Q_o$, and the output signal 6 is held in "H" level during the subtraction. If the content of the programmable counter 2 becomes 0 at time 24, the output signal 6 is made "L" level and the subtracting operation is terminated.

In the next output signal period, the output signal 6 having pulse width corresponding to the digital data $D_1$—$D_N$ is obtained again and is passed through the integrating circuit 4, thereby an analog output corresponding to the digital data $D_1$—$D_N$ is obtained.

In the above mentioned system, however, the width 21 of "H" level of the output 6 is in a specific position within the pulse period as shown in Figure 2. Therefore, when the output pulse waveform is expanded into Fourier series, the first order term becomes large and the fundamental frequency becomes small. In order to reduce ripple components of the output of the integrating circuit 4, the time constant of the integrating circuit must be increased, resulting in that the operation speed becomes low.

In view of the above mentioned disadvantages, the present invention is intended to provide a D—A converter employing pulse width modulation in which the time constant of the integrating circuit can be reduced and a high-speed operation becomes possible.

According to the invention, there is provided a D—A converter for converting digital data composed of most significant M bits $D_{N+1}, --- D_{N+M}$, and least significant N bits $D_1, ---, D_N$ where M and N are positive integers respectively into an analog quantity, comprising: frequency dividing circuit having M+N frequency dividers connected in tandem, a first frequency divider of said M+N frequency dividers being adapted to receive an input clock signal $Q_o$ and the remaining frequency dividers being adapted to generate output signals $Q_1, ---, Q_N, Q_{N+1}, ---$ and $Q_{N+M}$, respectively; a programmable counter of M bits for receiving the input clock signal $Q_o$; a preset circuit for receiving a signal $Q_L$ which has the same period as that of said output signal $Q_N$ and has a first level during an interval corresponding to one period of said clock signal $Q_o$ and a second level during the remaining portion of its period to preset values corresponding to the most significant M bits data $D_{N+1}, ---, D_{N+M}$ into said programmable counter when said output signal $Q_L$ is at said first level; a first, bistable logic circuit arranged to be set when said output signal $Q_L$ changes state from said first level to said second level and reset when the content of said programmable counter reaches a predetermined preset level; a decoder circuit for receiving said output signal $Q_1$ and outputs of said frequency divider circuit to generate output signals $Q^*_{M+1}; Q^*_{M+2}, ---, Q^*_{M+N}$ whose periods at a predetermined level do not overlap each other; a second logic circuit (31 to 34) for receiving least significant N data bits $D_1, ---, D_N$ and said output signals of said decoder circuit; and an integrating circuit for integrating the logical sum of the output signals of said first and second logic circuits, the second logic circuit being arranged to control passage of said decoder circuit output signals to said integrator in accordance with the logic levels of respective least significant data bits $D_1, ---, D_N$.

For a better understanding of the invention and to show how the same may be carried into effect, reference will now be made, by way of example, to the accompanying drawings, in which:

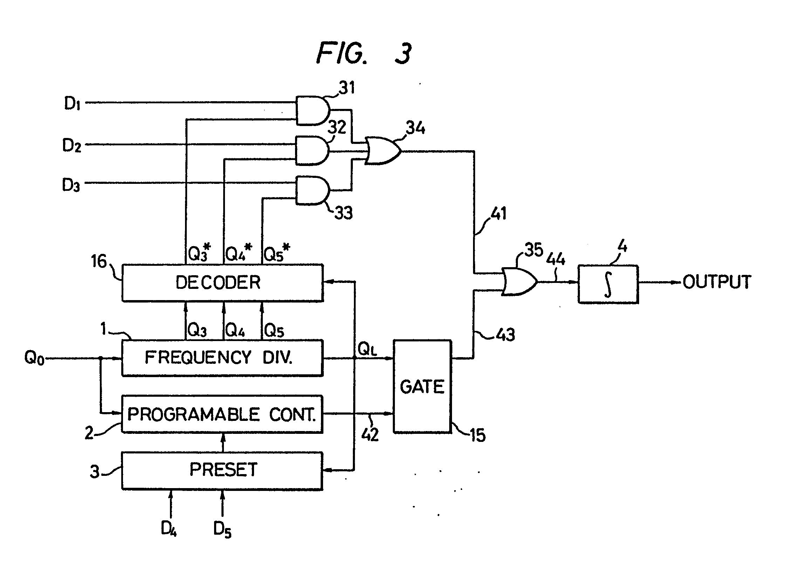

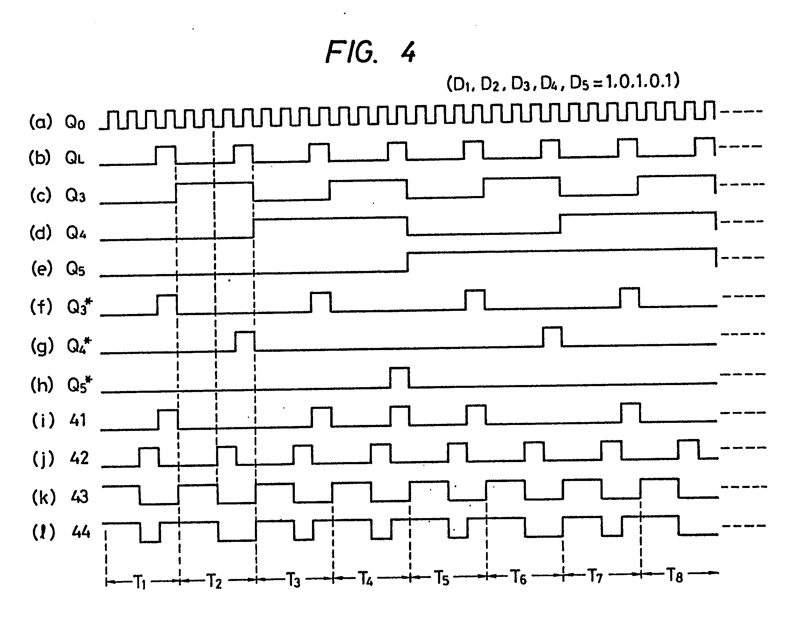

Figure 1 is a block diagram of an example of a prior art D—A converter; Figure 2 is a timing diagram illustrating the operation of Figure 1; Figure 3 is a block diagram of an embodiment of the present invention; and Figure 4 is a timing diagram illustrating the operating of Figure 3.

An embodiment of the present invention will now be explained referring to Figures 3 and 4. In Figure 3 an integrating type D—A converter comprises a frequency dividing circuit 1 including five frequency dividers connected in tandem to produce output signals $Q_1, ---, Q_5$, a programmable

counter 2 of two bits, a preset circuit 3, an integrating circuit 4, a gate circuit 15 to hold output constant during a certain time, AND circuits 31—33, and OR circuits 34, 35.

It is assumed that a digital quantity having five bits $D_1$, $D_2$, $D_3$, $D_4$, and $D_5$ of 1, 0, 1, 0 and 1, respectively, be inputted. First, output according to the data $D_4$, $D_5$ corresponding to most significant two bits will be explained. Values corresponding to $D_4$; $D_5$, for example, values 0, 1, 2 or 3 in decimal notation when binary digital data $D_4$, $D_5$ are [0.0] [1.0] [0.1] or [1.1], respectively, are preset to the programmable counter 2 through the preset circuit 3 in response to preset signal $Q_L$ shown in Figure 4. Preset timing is determined by the preset signal $Q_L$ in "H" level having a width corresponding to one period of clock $Q_0$ per every four periods of $Q_0$ (one period of $Q_L$, i.e. $Q_L$ has a period equal to that of $Q_2$). The programmable counter 2 counts clock $Q_0$ from the trailing edge time of $Q_L$, and when the content of the counter attains a prescribed value, i.e. value O in this example, the counter 2 provides an output signal 42 in Figure 3 to be sent to the gate circuit 15. An output 43 of the gate circuit 15 holds "H" level during end period from the trailing edge of present signal $Q_L$ until the next leading edge of the signal 42.

An output according to data $D_1$, $D_2$ and $D_3$ corresponding to least significant three bits will now be explained. The reference clock $Q_0$ is applied to the frequency dividing circuit 1 to obtain output signals $Q_3$—$Q_5$ in Figure 4 from the respective frequency dividers in the third, fourth and fifth stages. The output signals $Q_3$—$Q_5$ and the signal $Q_L$ are supplied to the decoder circuit 16, and output signals $Q*_3$—$Q*_5$ are obtained therefrom by a logic operation according to the following equations (1).

$$Q*_3 = \overline{Q_3} \cdot Q_L$$
$$Q*_4 = Q_3 \cdot \overline{Q_4} \cdot Q_L \qquad (1)$$
$$Q*_5 = Q_3 \cdot Q_4 \cdot \overline{Q_5} \cdot Q_L$$

The output signals thus obtained are processed by the AND circuits 31—33 in response to data bits $D_1$—$D_3$, and output signals of AND circuits 31—33 are entered to the OR circuit 34 from which a pulse output 41 is obtained. This pulse output 41 and the aforementioned pulse output 43 are supplied to the OR circuit 35, and output 44 of the circuit 35 is integrated by means of the integrating circuit 4. Therefore an analog output corresponding to digital data $D_1$—$D_5$ is obtained.

As clearly seen, the period of the output 44 is constituted from eight intervals $T_1$—$T_8$ shown in Figure 4. The difference in time duration of the "H" levels between the intervals $T_1$—$T_8$ is at most one corresponding to one period of $Q_0$ and so the period of the output 44 can be approximated by an interval $T_1$, that is, 1/8 of $T_1 + - - - + T_8 = T_1$. When this pulse output passes through the integrating circuit 4, ripple component of analog output can be reduced. If the number of bits in the digital data is made equal to that of the pulse output 6 from the conventional D—A converter shown in Figure 1, the interval 22 shown in Figure 2 is equal to a sum of the intervals, $T_1 + - - + T_8$, shown in Figure 4. Therefore, abovementioned fact is clearly understood from that the output 44 in the embodiment of the invention has period of "H" level distributed without being localized to a specific position.

Abovementioned matter will now be described quantitatively. In the conventional system shown in Figure 1, the fundamental period component of the pulse output (component whose period is equal to the interval 22) becomes maximum when the "H" level interval 21 becomes a half of the period 22. Assuming that the digital data bits be $D_1$—$D_5$, an amplitude of the output pulse 6 be $V_0$, and the period of the clock $Q_0$ be $t_0$, the fundamental period component $A_1$ becomes

$$A_1 = \frac{2V_0}{\pi} \qquad (2)$$

($\pi$: ratio of circumference of circle to its diameter)
Assuming that the time constant of the integrating circuit 4 be $\tau$, and when the pulse output 6 is supplied to the integrating circuit 4, the ripple component $VR_1$ of the output of the integrating circuit becomes

$$VR_1 = 32 \times \frac{V_0 t_0}{\pi 2 \tau} \qquad (3)$$

Next, the embodiment of the present invention in Figure 3 will be considered. The fundamental period component of the sum of the periods, $T_1 + - - - + T_8$ (equal to $32t_0$), of the pulse output 44 in Figure 3 becomes maximum when data $D_1$ is "1". Then the fundamental period component $A_2$ becomes

$$A_2 = 0.195 \times \frac{V_0}{\pi} \qquad (4)$$

When the pulse output is passed through the integrating circuit 4 having the time constant $\tau$, the ripple component $VR_2$ of the output therefrom becomes

$$VR_2 = 3.12 \times \frac{V_0 t_0}{2} \qquad (5)$$

When the time duration of "H" level in each of the intervals $T_1$—$T_8$ becomes equal, that is, $D_1$, $D_2$ and $D_3$ are O, the fundamental period of the pulse output 44 becomes $4t_0$. This component becomes maximum when the time duration of "H" level coincides with that of "L" level. Then the maximum fundamental period component $A_3$ becomes

$$A_3 = \frac{2V_o}{\pi} \qquad (6)$$

Therefore, the ripple component $VR_3$ contained in the output of the integrating circuit 4 becomes

$$VR_3 = 4 \times \frac{V_o t}{\pi 2\tau} \qquad (7)$$

As clearly seen from the equations (3), (5) and (7), the ripple component contained in the output of the intgegrating circuit 4 of the D—A converter of the present invention becomes 1/8—1/10 in comparison to the conventional D—A converter. In other words, according to the present invention, if the amount of the ripple contained in the analog output is made equal to that of the prior art converter, the time constant of the integrating circuit can be reduced, with the result that the conversion speed can be increased.

Although the D—A converter is constituted for five bits composed of most significant two bits and least significant three bits in the abovementioned embodiment, it is possible to constitute a D—A converter for two bits composed of the most significant one bit and least significant one bit, or more, by providing a proper number of stages (equal to the total number of bits) of the frequency dividing circuit 1 and a proper number of bits (equal to the number of most significant bits) of the programmable counter 2 in Figure 3.

Although the input from the frequency dividing circuit 1 is decoded according to equation (1) in the embodiment shown in Figure 3, a similar effect is obtained according to other concept than equation (1), provided that the intervals in "H" level (or "L" level) of decoded output are selected without mutual overlapping.

## Claims

1. A D—A converter for converting digital data composed of most significant M bits $D_{N+1}, ---, D_{N+M}$, and least significant N bits $D_1, ---, D_N$ where M and N are positive integers respectively into an analog quantity, comprising: a frequency dividing circuit (1) having M+N frequency dividers connected in tandem, a first frequency divider of said M+N frequency dividers being adapted to receive an input clock signal $Q_o$ and the remaining frequency dividers being adapted to generate output signals $Q_1, ---, Q_N, Q_{N+1}, ---$ and $Q_{N+M}$, respectively; a programmable counter (2) of M bits for receiving the input clock signal $Q_o$; a preset circuit (3) for receiving a signal $Q_L$ which has the same period as that of said output signal $Q_N$ and has a first level during an interval corresponding to one period of said clock signal $Q_o$ and a second level during the remaining portion of its period to preset values corresponding to the most significant M bits data $D_{N+1}, ---, D_{N+M}$ into said programmable counter when said output signal $Q_L$ is at said first level; a first bistable logic circuit (15) arranged to be set when said output signal $Q_L$ changes state from said first level to said second level and reset when the content of said programmable counter (2) reaches a predetermined preset level; a decoder circuit (16) for receiving said output signal $Q_1$ and outputs of said frequency divider circuit (1) to generate output signals $Q^*_{M+1}; Q^*_{M+2}, ---, Q^*_{M+N}$ whose periods at a predetermined level do not overlap each other; a second logic circuit (31 to 34) for receiving least significant N data bits $D_1, ---, D_N$ and said output signals of said decoder circuit (16); and an integrating circuit (4) for integrating the logical sum of the output signals of said first and second logic circuits, the second logic circuit being arranged to control passage of said decoder circuit output signals to said integrator in accordance with the logic levels of respective least significant data bits $D_1, ---, D_N$.

2. A D—A converter as claimed in Claim 1, characterised in that the decoder circuit (16) provides output signals represented by

$$Q^*_{M+1} = \overline{Q_{M+1}} \cdot Q_L$$

$$Q^*_{M+2} = Q_{M+1} \cdot \overline{Q_{M+2}} \cdot Q_L$$

$$\cdot$$
$$\cdot$$
$$\cdot$$

$$Q^*_{M+N} = Q_{M+1} \cdot Q_{M+2} ------ Q_{M+N-1} \cdot \overline{Q_{M+N}} \cdot Q_L.$$

## Patentansprüche

1. D/A-Wandler für die Umwandlung von Digitaldaten, die aus M höchstwertigen Bits $D_{N+1}, ---, D_{N+M}$, und N niederwertigsten Bits $D_1, ---, D_N$ zusammengesetzt sind, wobei M und N positive ganze Zahlen sind, in analoge Werte mit

—einem Frequenzteilerschaltkreis (1) mit M+N hintereinander (Tandem) geschalteten Frequenzteilern, von denen ein erster der M+N Frequenzteiler dafür angepaßt ist, ein Eingangstaktsignal $Q_o$ zu empfangen und die restlichen Frequenzteiler dafür angepaßt sind, Ausgangssignale $Q_1, ---, Q_N, Q_{N+1}^m ---$ und $Q_{N+M}$ zu erzeugen;

einem programmierbaren Zähler (2) mit M Bit für die Aufnahme des Eingangstaktsignals $Q_o$;

einem Voreinstellungsschaltkreis (3) für den Empfang eines Signals $Q_L$, das die gleiche Periode wie das Ausgangssignal $Q_N$ hat und das einen ersten Pegel während eines Intervalls, das mit einer Periode des Taktsignals $Q_o$ korrespondiert, und einen zweiten Pegel während des restlichen Teils von dessen Periode einnimmt, um im programmierbaren Zähler Werte voreinzustellen, die den M höchstwertigen Bitdaten $D_{N+1}, ---, D_{N+M}$ entsprechen, wenn das Ausgangssignal $Q_L$ einen ersten Pegel aufweist;

einem ersten bistabilsen Logikschaltkreis (15), der gesetzt wird, wenn das Ausgangssignal $Q_L$ seinen Zustand vom ersten Pegel zum zweiten Pegel ändert, und zurückgesetzt wird, wenn der Inhalt des programmierbaren Zählers (2) einen festgelegten voreingestellten Wert erreicht;

einem Dekoderschaltkreis (16) für den Empfang des Ausgangssignals $Q_1$ und die Ausgänge des Frequenzteilerschaltkreises (1), um Ausgangssignale $Q*_{M+1}$, $Q*_{M+2}$, - - -, $Q_{M+N}$ zu erzeugen, deren Perioden bei einem festgelegten Pegel einander nicht überlappen;

einem zweiten Logikschaltkreis (31 bis 34) für den Empfang der N niederwertigsten Datenbits $D_1$, - - -, $D_N$ und der Ausgangssignale des Dekoderschaltkreises (16); und

einem logischen Integrierschaltkreis (4) für die Integration der logischen Summe der Ausgangssignale des ersten und zweiten Logikschaltkreises, wobei der zweite Logikschaltkreis dafür angepaßt ist, den Durchgang der Ausgangssignale des Dekoderschaltkreises zu dem Integrierer in Übereinstimmung mit den logischen Pegeln der niederwertigsten Datenbits $D_1$, - - - $D_N$ zu steuern.

2. D/A-Wandler nach Anspruch 1, dadurch gekennzeichnet, daß der Dekoderschaltkreis (16) Ausgangssignale bereitstellt, die wiedergegeben werden durch:

$$Q*_{M+1} = \overline{Q_{M+1}} \cdot Q_L$$

$$Q*_{M+2} = Q_{M+1} \cdot \overline{Q_{M+2}} \cdot Q_L$$

$$\cdot$$
$$\cdot$$
$$\cdot$$

$$Q*_{M+N} = Q_{M+1} \cdot Q_{M+2} \text{- - - - - -}$$
$$Q_{M+N-1} \cdot \overline{Q_{M+N}} \cdot Q_L.$$

## Revendications

1. Un convertisseur numérique-analogique destiné à convertir des données numériques constituées de M bits de poids fort $D_{N+1}$, - - -, $D_{N+M}$, et de N bits de poids faible $D_1$, - - -, $D_N$ où M et N sont des nombres entiers positifs respectivement, en une quantité analogique, comprenant: un circuit divisant les fréquences (1) muni de diviseurs de fréquence M+N reliés en tandem, un premier diviseur de fréquence de ces diviseurs de fréquence M+N étant adapté de façon à recevoir un signal d'horloge d'entrée $Q_o$ et les diviseurs de fréquence restants étant adaptés de façon à générer des signaux de sortie $Q_1$, - - -, $Q_N$, $Q_{N+1}$, - - - et

$Q_{N+M}$, respectivement; un compteur programmable (2) de M bits destiné à recevoir le signal d'horloge d'entrée $Q_o$; un circuit préréglé (3) destiné à recevoir un signal $Q_L$ qui a la même période que celle de ce signal de sortie $Q_N$ et qui a un premier niveau pendant un intervalle correspondant à une période de ce signal d'horloge $Q_o$ et un second niveau pendant la partie restante de sa période pour prérégler des valeurs correspondant aux données de M bits de poids fort $D_{N+1}$, - - -, $D_{N+M}$ dans ce compteur programmable lorsque ce signal de sortie $Q_L$ est à ce premier niveau; un premier circuit logique bistable (15) disposé pour être réglé lorsque ce signal de sortie $Q_L$ change d'état à partir de ce premier niveau en ce second niveau et réglé à nouveau lorsque le contenu de ce compteur programmable (2) atteint un niveau préréglé prédéterminé; un circuit décodeur (16) destiné à recevoir ce signal de sortie $Q$ et les sorties de ce circuit diviseur de fréquence (1) pour générer des signaux de sortie $Q*_{M+1}$; $Q*_{M+2}$, - - -, $Q*_{M+N}$ dont les périodes à un niveau prédéterminé ne se chevauchent pas; un second circuit logique (31 à 34) destiné à recevoir N bits de données de poids faible $D_1$, - - -, $D_N$ et ces signaux de sortie de ce circuit décodeur (16); et un circuit d'intégration (4) destiné à intégrer la somme logique des signaux de sortie de ces premier et second circuits logiques étant disposés de façon à contrôler le passage de ces signaux de sortie du circuit décodeur vers cet intégrateur conformément aux niveau logiques des données de bits de poids faible respectives $D_1$, - - -, $D_N$.

2. Un convertisseur numérique-analogique selon la revendication 1, caractérisé en ce que le circuit décodeur (16) fournit des signaux de sortie représentés par

$$Q*_{M+1} = \overline{Q_{M+1}} \cdot Q_L$$

$$Q*_{M+2} = Q_{M+1} \cdot \overline{Q_{M+2}} \cdot Q_L$$

$$\cdot$$
$$\cdot$$

$$Q*_{M+N} = Q_{M+1} \cdot Q_{M+2} \text{- - - - - -}$$
$$Q_{M+N-1} \cdot \overline{Q_{M+N}} \cdot Q_L.$$

## FIG. 1

## FIG. 2

FIG. 3

FIG. 4